# EUROPEAN PATENT APPLICATION

(11) **EP 4 395 490 A1**
(43) Date of publication of application: **03.07.2024**
(21) Application number: 22934524.4
(22) Date of filing: 02.06.2022
(51) Int. Cl.: H10B 12/00

(54) **SEMICONDUCTOR MEMORY DEVICE AND MANUFACTURING METHOD AND READ/WRITE METHOD THEREFOR, AND ELECTRONIC DEVICE AND MEMORY CIRCUIT**

(30) Priority: 02.04.2022 CN 202210351841
(71) Applicant: Beijing Superstring Academy of Memory Technology, Beijing 100176 (CN)
(72) Inventor: ZHU, Zhengyong, Beijing 100176 (CN); KANG, Bokmoon, Beijing 100176 (CN); WANG, Guilei, Beijing 100176 (CN); ZHAO, Chao, Beijing 100176 (CN)
(74) Representative: Cabinet Beau de Loménie
(86) International application number: PCT/CN2022/096933
(87) International publication number: WO 2023/184699

(57) **Abstract**

A semiconductor memory device (10) and a manufacturing method and a read/write method therefor, and an electronic device and a memory circuit. A transistor (11) is arranged in each memory unit (101) in the semiconductor memory device (10), wherein a gate electrode (115) and a secondary electrode (116) are arranged in the transistor (11), and the secondary electrode (116) is electrically connected to a drain electrode (112). When a write operation is performed, a first voltage is applied to the gate electrode (115) by means of a word line (31), and an electrical signal is then applied to a source electrode (113) by means of a bit line (32) and according to external input data; and when a read operation is performed, by using the effect of a voltage of the secondary electrode (116) on a threshold voltage of the transistor (11), a second voltage is applied to the secondary electrode (116) by means of the word line (31), and the magnitude of the second voltage is between a threshold voltage of when the transistor (11) stores "1" and a threshold voltage of when the transistor (11) stores "0", and data is then read by means of detecting the magnitude of an output current of a field effect transistor.

## Description

### CORRS-REFERENCE TO RELATED APPLICATION

This application is based upon and claims priority to Chinese Patent Application No. 202210351841.1, filed on April 2, 2022, the disclosure of which is herein incorporated by reference in its entirety.

### TECHNICAL FIELD

The present disclosure relates to the technical field of semiconductor memory devices, and in particular, relates to a semiconductor memory device and a method for manufacturing, and reading and writing the same, an electronic device and a memory circuit.

### BACKGROUND

Dynamic random access memory (DRAM) is a semiconductor memory device. Compared to static random access memory, DRAM has the advantages of simpler structure, lower manufacturing cost, and higher capacity density. With the development of technology, DRAM is increasingly widely used.

However, the current DRAM has the disadvantages of more complex structure and lower degree of integration, which impose limitations on the application of DRAM.

### SUMMARY

Embodiments of the present disclosure provide a semiconductor memory device and a method for manufacturing, and reading and writing the same, an electronic device, and a memory circuit, for reducing leakage current that may be generated in a read/write state when ensuring a high degree of integration of the device, such that the semiconductor memory device has a compact structure and improved memory performance.

According to some embodiments of the present disclosure, a semiconductor memory device is provided. The semiconductor memory device includes: a substrate and a plurality of memory units disposed on the substrate, each of the memory units including a transistor, a bit line, and a word line; wherein the transistor includes: a drain electrode, arranged over the substrate; a gate electrode, arranged over the drain electrode, wherein the gate electrode is insulated from the drain electrode, and the gate electrode is electrically connected to the word line; a secondary electrode, arranged over the drain electrode surrounding an outer sidewall of the gate electrode, wherein the secondary electrode is insulated from the gate electrode, the secondary electrode is not overlapped with the gate electrode in a first direction perpendicular to an upper surface of the substrate, and the secondary electrode is electrically connected to the drain electrode; a semiconductor layer, surrounding the gate electrode, wherein the semiconductor layer is insulated from the gate electrode and the secondary electrode, and the semiconductor layer is electrically connected to the drain electrode; and a source electrode, arranged over the secondary electrode surrounding the outer sidewall of the gate electrode, wherein the source electrode is electrically connected to the semiconductor layer and the bit line, and the source electrode is insulated from the gate electrode and the secondary electrode.

In some embodiments, the secondary electrode is at least partially overlapped with the source electrode in the first direction.

In some embodiments, the secondary electrode is at least partially overlapped with the drain electrode in the first direction.

In some embodiments, an orthographic projection of an outer sidewall of the secondary electrode on a plane parallel to the upper surface of the substrate is outside an orthographic projection of the source electrode on the plane and within an orthographic projection of the drain electrode on the plane.

In some embodiments, the semiconductor layer is arranged between the gate electrode and the secondary electrode.

In some embodiments, the semiconductor memory device further includes a conductive connector, wherein the secondary electrode is electrically connected to the drain electrode via the conductive connector.

In some embodiments, wherein the conductive connector surrounds the secondary electrode.

In some embodiments, the semiconductor layer includes a monocrystalline semiconductor material, a polycrystalline semiconductor material, or a metal oxide semiconductor.

In some embodiments, the metal oxide semiconductor includes at least one of In, Ga, Zn, Sn, or W.

In some embodiments, the semiconductor memory device includes a plurality of stacked array modules, each of the stacked array modules including a plurality of the memory units arranged in an array; wherein the gate electrodes in each row of the transistors are connected to one of the word lines; and the source electrodes in each column of the transistors are connected to one of the bit lines.

According to some embodiments of the present disclosure, a semiconductor memory device is provided. The semiconductor memory device includes: a gate electrode, arranged on a substrate, extending in a first direction perpendicular to an upper surface of the substrate, and having a column shape, wherein the gate electrode is electrically connected to a word line; a semiconductor layer, wherein at least a portion of the semiconductor layer surrounds a sidewall of the gate electrode; a source electrode, surrounding an outer sidewall of the semiconductor layer and electrically connected to the semiconductor layer, wherein the source electrode is electrically connected to a bit line; a drain electrode, electrically connected to the semiconductor layer at a lower portion of the semiconductor layer, wherein the drain electrode is spaced apart from the source electrode in the first direction; a first insulator layer, arranged between the gate electrode and the semiconductor layer and between the gate electrode and the drain electrode; a secondary electrode, surrounding the outer sidewall of the semiconductor layer between the source electrode and the drain electrode in the first direction; and a second insulator layer, disposed between the secondary electrode and the semiconductor layer and between the secondary electrode and the source electrode, such that the secondary electrode is insulated from both the semiconductor layer and the source electrode, wherein the secondary electrode is electrically connected to the drain electrode.

In some embodiments, the secondary electrode extends in the first direction from the source electrode toward the drain electrode.

In some embodiments, the secondary electrode is at least partially overlapped with the drain electrode in the first direction.

In some embodiments, an orthographic projection of an outer sidewall of the secondary electrode on a plane parallel to the upper surface of the substrate is outside an orthographic projection of the source electrode on the plane and within an orthographic projection of the drain electrode on the plane.

In some embodiments, the semiconductor layer surrounds the sidewall of the gate electrode and a lower surface of the gate electrode in a U-like pattern, and the first insulator layer is formed between the semiconductor layer and the gate electrode in a U-like pattern, such that the semiconductor layer is insulated from the gate electrode.

In some embodiments, the drain electrode is arranged to surround a lower portion of the outer sidewall of the semiconductor layer and to be in contact with the lower portion of the outer sidewall of the semiconductor layer.

In some embodiments, the drain electrode is disposed between the substrate and the semiconductor layer and is in contact with a lower surface of the semiconductor layer.

In some embodiments, the drain electrode includes a first portion disposed between the substrate and the semiconductor layer and a second portion extending outwardly from the first portion in a second direction parallel to the upper surface of the substrate, the second portion of the drain electrode being at least partially overlapped with the secondary electrode in the first direction.

In some embodiments, the second portion of the drain electrode is in direct contact with the secondary electrode.

In some embodiments, the secondary electrode is spaced apart from the second portion of the drain electrode in the first direction by the second insulator layer, and the secondary electrode is electrically connected to the second portion of the drain electrode by a conductive connector.

In some embodiments, the conductive connector surrounds the outer sidewall of the semiconductor layer in an annular pattern and is connected to the second portion of the drain electrode by extending in the first direction.

In some embodiments, an orthographic projection of the conductive connector on a plane parallel to the upper surface of the substrate is within an orthographic projection of the secondary electrode on the plane.

In some embodiments, the conductive connector electrically connects a portion of an outer sidewall of the secondary electrode to an end of the second portion of the drain electrode; and an orthographic projection of the conductive connector on a plane parallel to the upper surface of the substrate is outside an orthographic projection of the secondary electrode on the plane.

In some embodiments, the word line and the bit line are both disposed over the gate electrode and are insulated from each other at different layers.

In some embodiments, the source electrode and the secondary electrode are at least partially overlapped with each other in the first direction.

In some embodiments, the semiconductor memory device further includes: an additional electrode, at least partially overlapped with the secondary electrode in the first direction.

According to some embodiments of the present disclosure, a memory circuit is provided. The memory circuit includes: a gate electrode, a secondary electrode, a source electrode, a drain electrode, a word line, and a bit line, wherein the gate electrode is electrically connected to the word line, the source electrode is electrically connected to the bit line, the drain electrode is electrically connected to the secondary electrode, the gate electrode is insulated from the secondary electrode, the gate electrode is insulated from the source electrode and the drain electrode, and the secondary electrode is insulated from the source electrode and the drain electrode; and node capacitors of the secondary electrode and the drain electrode form a memory capacitor.

According to some embodiments of the present disclosure, an electronic device is provided. The electronic device includes the semiconductor memory device as described above.

According to some embodiments of the present disclosure, a method for manufacturing a semiconductor memory device is provided. The method includes: providing a substrate; forming a drain electrode over the substrate by a patterning process; successively forming a source electrode, a semiconductor layer, and a gate electrode over the drain electrode; and forming a secondary electrode and conductive connectors over the drain electrode, wherein the secondary electrode is not overlapped with the gate electrode in a first direction perpendicular to an upper surface of the substrate, and each of the conductive connectors is electrically connected to both the secondary electrode and the drain electrode.

In some embodiments, successively forming the source electrode, the semiconductor layer, and the gate electrode over the drain electrode includes: forming a sacrificial layer over the drain electrode, wherein the sacrificial layer covers the drain electrode; forming the source electrode over the sacrificial layer by a patterning process; forming a first dielectric layer on the source electrode, wherein the first dielectric layer covers the source electrode and the drain electrode; opening a via successively running through the first dielectric layer, the source electrode, and the sacrificial layer, wherein a bottom of the via exposes the drain electrode, and a wall of the via exposes the source electrode; and successively forming the semiconductor layer, the first insulator layer, and the gate electrode within the via, wherein the semiconductor layer is electrically connected to the source electrode and the drain electrode.

In some embodiments, forming the secondary electrode and the conductive connectors on a side, away from the substrate, of the drain electrode includes: exposing two ends of the drain electrode by removing portions of the first dielectric layer and the sacrificial layer by a patterning process; forming an accommodation space by removing the other portion of the sacrificial layer, such that the drain electrode, the source electrode, and the semiconductor layer are exposed; forming a second insulator layer by deposition and causing the second insulator layer to cover the exposed semiconductor layer, the exposed source electrode, and the exposed drain electrode; forming a secondary electrode on the second insulator layer by deposition and causing the secondary electrode to fill the accommodation space; and forming the conductive connectors at the two exposed ends of the drain electrode by deposition, such that each of the conductive connectors is connected to both the drain electrode and the secondary electrode.

In some embodiments, after forming the secondary electrode and the conductive connectors on the side, away from the substrate, of the drain electrode, the method further includes: forming a word line by a patterning process, such that the word line is electrically connected to the gate electrode; and forming a bit line by a patterning process, such that the bit line is electrically connected to the source electrode.

According to some embodiments of the present disclosure, a method for reading and writing a semiconductor memory device as described above is provided. The method includes: in a writing state, turning a transistor on by applying a first voltage to a gate electrode by a word line, and applying a data signal to a source electrode over a bit line, wherein the data signal is stored by the turned-on transistor to a memory capacitor connected to the drain electrode and the secondary electrode; and in a reading state, applying a second voltage to the gate electrode by the word line, and reading out the data signal by measuring a current on the source electrode by the bit line.

The technical solutions according to the embodiments of the present disclosure achieve at least the following beneficial effects.

In the semiconductor memory device according to the present disclosure, one transistor is arranged in each memory unit, wherein the gate electrode and the secondary electrode are arranged in the transistor, and the secondary electrode is electrically connected to the drain electrode. The first voltage is applied to the gate electrode by the word line during the writing operation, and then the electrical signal is applied to the source electrode over the bit line based on the external input data. The source electrode transmits the electrical signal to the drain electrode, the drain electrode transmits the electrical signal to the secondary electrode, and the node capacitors of the secondary electrode and the drain electrode form the memory capacitor of the memory unit, such that the writing of the data is achieved. During the reading operation, the second voltage is applied to the secondary electrode by the word line (the magnitude of the second voltage is between the threshold voltage of the transistor when storing "1" and the threshold voltage of the transistor when storing "0") using the influence of the voltage of the secondary electrode on the threshold voltage of the transistor, and then the data is read out by detecting the magnitude of the output current of the transistor. Therefore, the reading and writing of data is achieved by providing only one transistor in the memory unit, and there is no need to provide other transistors and capacitors, which greatly simplifies the structure of the memory unit and is conducive to improving the degree of integration and memory density of the semiconductor memory device.

### BRIEF DESCRIPTION OF DRAWINGS

The above-mentioned and/or additional aspects and advantages of the present disclosure will become apparent and readily understood from the following description of embodiments in conjunction with the accompanying drawings, wherein:
FIG. 1 is a cross-sectional schematic structural diagram of a memory unit in a semiconductor memory device according to some embodiments of the present disclosure;
FIG. 2 is a top view of a schematic structural diagram of a memory unit in a semiconductor memory device according to some embodiments of the present disclosure;
FIG. 3 is a cross-sectional schematic structural diagram of a semiconductor memory device according to some embodiments of the present disclosure;
FIG. 4 is a schematic structural diagram of a memory circuit according to some embodiments of the present disclosure;
FIG. 5 is a schematic diagram of a circuit structure of a semiconductor memory device according to some embodiments of the present disclosure;
FIG. 6 is a graph of transfer characteristics of a transistor in a semiconductor memory device when different data is written;
FIG. 7 is a flowchart of a method for manufacturing a semiconductor memory device according to some embodiments of the present disclosure;
FIG. 8a to FIG. 8s are schematic structural diagrams of different processes for manufacturing a semiconductor memory device according to some embodiments of the present disclosure; and
FIG. 9 is a flowchart of a method for reading and writing a semiconductor memory device according to some embodiments of the present disclosure.

### DETAILED DESCRIPTION

The present disclosure is described in further detail hereinafter, and examples of embodiments of the present disclosure are illustrated in the accompanying drawings, wherein the same or similar reference numerals throughout denote the same or similar components or components having the same or similar features. In addition, the detailed description of the related art is omitted where it is not necessary for the illustrated features of the present disclosure. The embodiments described hereinafter with reference to the accompanying drawings are exemplary and are intended only to explain the present disclosure and are not to be construed as a limitation of the present disclosure.

It should be appreciated by those skilled in the art that, unless otherwise defined, the singular forms "one," "a," "the," and "the" used herein may also include the plural forms. It should be further understood that the term "include" used herein refers to the presence of the described features, integers, steps, operations, elements, and/or components, but does not preclude the presence or addition of one or more other features, integers, steps, operations, elements, components, and/or groups thereof. It should be understood that when a component is "connected" or "coupled" to another component, it may be directly connected or coupled to the other component, or there may be intermediate components. Furthermore, "connected" or "coupled" used herein may include wirelessly connected or wirelessly coupled. The term "and/or" used herein includes all or any of the units and all combinations of one or more associated listed items.

The inventors of the present disclosure take into account that a memory unit in the conventional DRAM usually includes a transistor and a capacitor, and the main principle of operation of the memory unit is to use the capacitor to store charges and to determine whether a binary bit is a 1 or a 0 by the quantity of charges stored in the capacitor. In the memory unit configured with the transistor/capacitor (1T/1C), the capacitor C is used to store charges for indicating numbers "1" and "0," and the transistor is used to perform the writing operation and reading operation. In the memory unit configured with the 1T/1C, the leakage current is large, which affects the memory performance of the memory unit. In addition, to increase the data memory time and decrease the refresh rate, a capacitor having a large capacitance is usually required, and thus the capacitance of the capacitor is increased by increasing an area of an electrode of the capacitor. As a result, an occupied area of the memory unit on the substrate is increased, and the degree of integration of the semiconductor memory device is decreased.

To increase the degree of integration of the semiconductor memory device, in the related art, two-transistors/zero-capacitor (2T/0C) is arranged in the memory unit, i.e., a gate capacitor of one of the two transistors is utilized as a memory capacitor. However, for the semiconductor memory device arranged in the 2T/0C way, the structure of the memory unit is still not compact enough, and there is still room for further improvement in the degree of integration and memory density of the semiconductor memory device.

The present disclosure provides a semiconductor memory device, a method for manufacturing, and reading and writing the same, and a memory device, which are intended to reduce the leakage current while ensuring a high degree of integration.

A secondary electrode is added in the present application, which is electrically connected to a drain electrode and is disposed on a side of a channel. An insulator layer is arranged between the secondary electrode and the channel, and a gate electrode is arranged on the other side of the channel. The secondary electrode serves as both a back gate and a memory electrode, regulating a smaller off-state current of a transistor while storing charges, such that a low refreshing frequency is achieved without adding an extra capacitor. Further, the charge memory capacity is greater where an additional capacitor is added.

The semiconductor memory device and a method for manufacturing, and reading and writing the same, the electronic device, and the memory circuit according to various embodiments of the present disclosure are described in detail hereinafter with reference to the accompanying drawings.

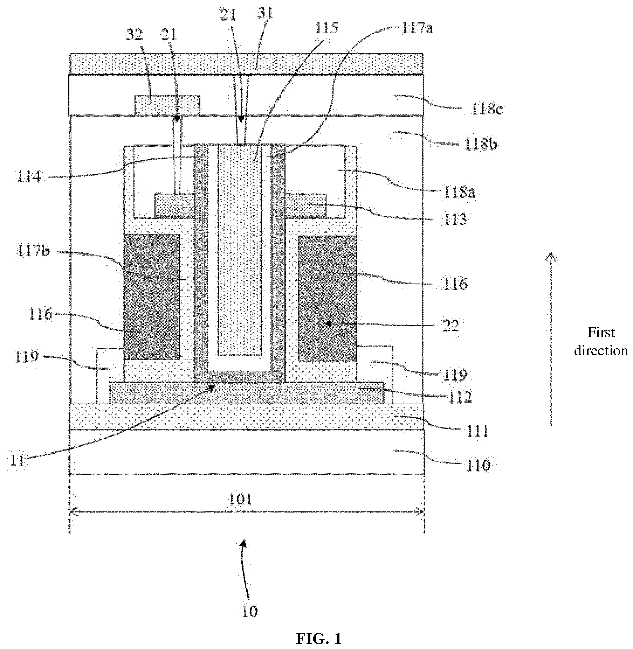

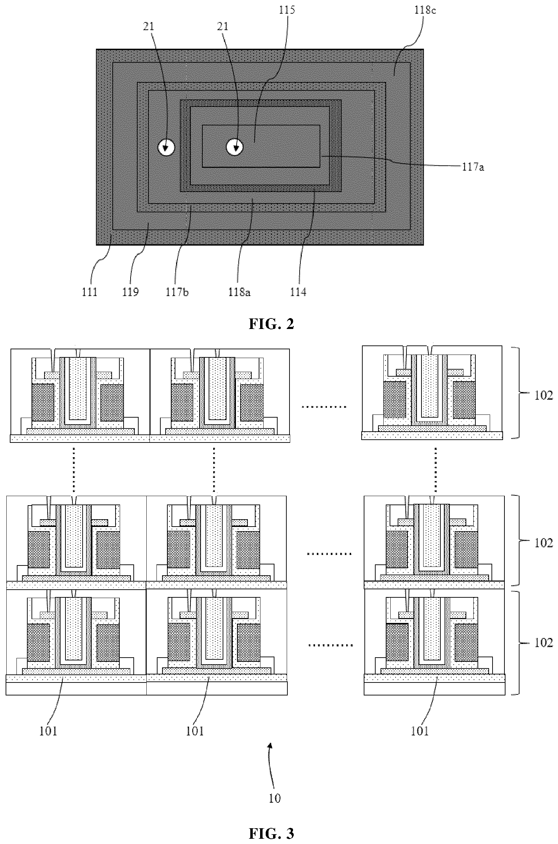

FIG. 1 is a cross-sectional diagram of a memory unit in a semiconductor memory device according to some embodiments of the present disclosure. Only one memory unit of a plurality of memory units arranged in an array in the semiconductor memory device 10 is shown in FIG. 1. FIG. 2 shows an orthographic projection diagram of a partial region of some of the components of the memory unit shown in FIG. 1.

As shown in FIG. 1, the semiconductor memory device 10 includes a substrate 110 and a plurality of memory units 101 disposed on the substrate 110. Each of the memory units 101 includes a transistor 11, a bit line 32, and a word line 31. The transistor 11 includes a drain electrode 112, a gate electrode 115, a secondary electrode 116, a semiconductor layer 114, and a source electrode 113.

The substrate 110 is a silicon substrate, a glass substrate, a flexible substrate, or the like, which is not limited herein. The substrate 110 has an upper surface and a lower surface opposite to each other.

The gate electrode 115 is also referred to as a first gate electrode, and the secondary electrode 116 is also referred to as a second gate electrode. The gate electrode 115 is connected to the word line 31 to control an on/off of the transistor 11, and the secondary electrode 116 is defined relative to the gate electrode 115. The gate electrode 115 is disposed on a front side of a channel of the semiconductor layer, and the secondary electrode 116 is disposed on a back side of the channel of the semiconductor layer. Both the gate electrode 115 and the secondary electrode 116 serve to control a current to the transistor, and both serve as a role of the gate electrode. However, the secondary electrode 116 does not serve to control the transistor to turn on and turn off, but rather to control the transistor to minimize the loss of leakage current, and the gate electrode 115 is configured to control the transistor to turn on or turn off under the influence of a voltage of the word line.

In some embodiments, the gate electrode 115 is arranged on the substrate 110 and extends along a first direction perpendicular to the upper surface of the substrate 110 and has a column shape. The gate electrode 115 is electrically connected to the word line 31.

An interlayer insulator layer 111 is arranged on the upper surface of the substrate 110, and the drain electrode 112 is arranged on the interlayer insulator layer 111.

The semiconductor layer 114 is arranged on the interlayer insulator layer 111, and at least a portion of the semiconductor layer 114 surrounds a sidewall of the gate electrode 115.

The semiconductor layer 114 is made of a monocrystalline semiconductor material, a polycrystalline semiconductor material, or a metal oxide semiconductor. Alternatively, the metal oxide semiconductor includes at least one of In, Ga, Zn, Sn, or W.

The source electrode 113 is arranged to surround an outer sidewall of the semiconductor layer 114 and is electrically connected to the semiconductor layer 114. The source electrode 113 is electrically connected to the bit line 32.

The drain electrode 112 is arranged to be electrically connected to the semiconductor layer 114 at a lower portion of the semiconductor layer 114. In addition, the drain electrode 112 is spaced apart from the source electrode 113 in the first direction.

A first insulator layer 117a is arranged between the gate electrode 115 and the semiconductor layer 114, and between the gate electrode 115 and the drain electrode 112.

The secondary electrode 116 surrounds the outer sidewall of the semiconductor layer 114 between the source electrode 113 and the drain electrode 112 in the first direction.

A second insulator layer 117b is arranged between the secondary electrode 116 and the semiconductor layer 114 and between the secondary electrode 116 and the source electrode 113, such that the secondary electrode 116 is insulated from both the semiconductor layer 114 and the source electrode 113. In addition, the secondary electrode 116 is electrically connected to the drain electrode 112.

Specifically, the secondary electrode 116 extends in the first direction from the source electrode 113 toward the drain electrode 112. In some embodiments, the secondary electrode 116 is at least partially overlapped with the drain electrode 112 in the first direction. That is, an orthographic projection of the secondary electrode 116 on a plane parallel to the upper surface of the substrate 110 is overlapped with an orthographic projection of the drain electrode 112 on the plane parallel to the upper surface of the substrate 110.

In some embodiments, an orthographic projection of an outer sidewall of the secondary electrode 116 on the plane parallel to the upper surface of the substrate 110 is outside an orthographic projection of the source electrode 113 on that plane and is within the orthographic projection of the drain electrode 112 on that plane.

As shown in FIG. 1, the semiconductor layer 114 surrounds a sidewall of the gate electrode 115 and a lower surface of the gate electrode 115 in a U-like pattern, and the first insulator layer 117a is formed in a U-like pattern between the semiconductor layer 114 and the gate electrode 115, such that the semiconductor layer 114 is insulated from the gate electrode 115.

As shown in FIG. 1, the drain electrode 112 is arranged between the substrate 110 and the semiconductor layer 114 and is in contact with a lower surface of the semiconductor layer 114.

As shown in FIG. 1, the drain electrode 112 is arranged between the substrate 110 and the semiconductor layer 114, but unlike what is shown in FIG. 1, the drain electrode 112 alternatively surrounds a lower portion of the outer sidewall of the semiconductor layer 114 and is in contact with the lower portion of the outer sidewall of the semiconductor layer 114.

Specifically, as shown in FIG. 1, the drain electrode 112 includes a first portion disposed between the substrate 110 and the semiconductor layer 114 and a second portion extending outwardly from the first portion along a second direction parallel to the upper surface of the substrate 110. Alternatively, the second portion of the drain electrode 112 is at least partially overlapped with the secondary electrode 116 in the first direction.

In some embodiments, although not shown in the accompanying drawings, the second portion of the drain electrode 112 is in direct contact with the secondary electrode 116.

In some other embodiments, as shown in FIG. 1, the secondary electrode 116 is spaced apart from the second portion of the drain electrode 112 in the first direction by the second insulator layer 117b, and the secondary electrode 116 is electrically connected to the second portion of the drain electrode 112 by a conductive connector 119.

Specifically, the secondary electrode 116 is electrically connected to an end of the second portion of the drain electrode 112 by the conductive connector 119.

Although not shown in the accompanying drawings, the conductive connector 119 surrounds the outer sidewall of the semiconductor layer 116 in an annular pattern and extends downward in the first direction (e.g., extends through the second insulator layer 117b) to be connected to the second portion of the drain electrode 112. Additionally, an orthographic projection of the conductive connector 119 on the plane parallel to the upper surface of the substrate 110 is within the orthographic projection of the secondary electrode 116 on that plane.

In some other embodiments, the conductive connector 119 electrically connects a portion of the outer sidewall of the secondary electrode 116 to the end of the second portion of the drain electrode 112. In this case, as shown in FIG. 2, the orthographic projection of the conductive connector 119 on the plane parallel to the upper surface of the substrate 110 is outside the orthographic projection of the secondary electrode 116 on that plane.

Both the word line 31 and the bit line 32 are disposed over the gate electrode 115 and are insulated from each other at different layers.

As shown in FIG. 1, the source electrode 113 and the secondary electrode 116 are at least partially overlapped in the first direction. That is, the orthographic projection of the source electrode 113 on the plane parallel to the upper surface of the substrate 110 is overlapped with the orthographic projection of the secondary electrode 116 on that plane.

In addition, the semiconductor memory device 10 further includes an additional electrode (not shown) that is at least partially overlapped with the secondary electrodes 116 in the first direction. The additional electrode and the secondary electrodes 116 together form two opposite electrodes of the capacitor.

As shown in FIG. 1, an orthographic projection of the gate electrode 115 on the plane parallel to the upper surface of the substrate 110 is overlapped with the orthographic projection of the drain electrode 112 on the plane parallel to the upper surface of the substrate 110, and the gate electrode 115 is insulated from the drain electrode 112.

However, in some other embodiments, an orthographic projection of the gate electrode 115 on the substrate 110 is not overlapped with an orthographic projection of the drain electrode 112 on the substrate 110.

As shown in FIG. 1, the secondary electrode 116 is arranged on an upper surface, going away from the substrate 110, of the drain electrode 112. The orthographic projection of the secondary electrode 116 on the substrate 110 is overlapped with the orthographic projection of the drain electrode 112 on the substrate 110. The secondary electrode 116 is insulated from the gate electrode 115. The orthographic projection of the secondary electrode 116 on the substrate 110 is not overlapped with the orthographic projection of the gate electrode 115 on the substrate 110.

The semiconductor layer 114 surrounds the gate electrode 115. As shown in FIG. 1, an orthographic projection of the semiconductor layer 114 on the substrate 110 is overlapped with the orthographic projection of the drain electrode 112 on the substrate 110, the semiconductor layer 114 is insulated from the gate electrode 115 and the secondary electrodes 116, and the semiconductor layer 114 is electrically connected to the drain electrode 112.

The source electrode 113 is electrically connected to the semiconductor layer 114 and the bit line 32, and the source electrode 113 is insulated from the gate electrode 115 and the secondary electrode 116.

Specifically, in conjunction with FIG. 1 through FIG. 5, the substrate 110 includes silicon or glass, and the plurality of memory units 101 disposed on the substrate 110 are arranged in an array.

The drain electrode 112 is formed by a patterning process. The semiconductor layer 114, the gate electrode 115, the first insulator layer 117a, the second insulator layer 117b, the secondary electrode 116, and the source electrode 113 are disposed on the upper surface, going away from the substrate 110, of the drain electrode 112.

The source electrode 113 is disposed on a surface, going away from the substrate 110, of the secondary electrode 116. That is, the drain electrode 112, the secondary electrode 116, and the source electrode 113 are successively stacked along the first direction in FIG. 1. The gate electrode 115 and the secondary electrode 116 extend upwardly in the first direction on the substrate 110. That is, a length of the gate electrode 115 and a length of the secondary electrode 116 in the first direction in FIG. 1 are respectively greater than the lengths of the two electrodes in the other directions.

The gate electrode 115 is insulated from the semiconductor layer 114, the source electrode 113, and the drain electrode 112 by the first insulator layer 117a, the secondary electrode 116 is insulated from the semiconductor layer 114, the source electrode 113, and the drain electrode 112 by the second insulator layer 117b, and the source electrode 113, and the drain electrode 112 are electrically connected to the semiconductor layer 114. The source electrode 113, the drain electrode 112, the gate electrode 115, the secondary electrode 116, and the semiconductor layer 114 are stacked to form a three-dimensionally structured transistor 11 (the semiconductor layer 114, the gate electrode 115, and the secondary electrode 116 all extend in a direction perpendicular to the substrate 110). The secondary electrode 116 is electrically connected to the drain electrode 112. The memory unit 101 includes the word line 31 and the bit line 32. The word line 31 is electrically connected to the gate electrode 115, and the bit line 32 is electrically connected to the source electrode 113.

In a case where the semiconductor memory device 10 is in a writing mode of operation, a first voltage is applied to the gate electrode 115 by the word line 31, and the first voltage is a turn-on voltage (e.g., +5 V), at which time the channel of the transistor is in an on state, and a voltage of the source electrode is approximately equal to a voltage of the drain electrode. At the same time, a data signal is input by applying a voltage to the source electrode 113 over the bit line 32, and the voltage at the drain electrode 112 is equal to a voltage of the data signal input to the source electrode. Because the drain electrode 112 and the secondary electrode 116 are electrically connected, in this case, the magnitude of the voltages on the source electrode 113 and the drain electrode 112 are the same as the magnitude of the voltage on the secondary electrode 116 (the drain electrode 112 and the secondary electrode 116 have the same potential). Node capacitors of the secondary electrode 116 and the drain electrode 112 constitute a memory capacitor 103 of the memory unit 101, and the magnitude of the voltage on the secondary electrode 116 determines the quantity of charges in the memory capacitor, which in turn determines whether a binary of the data signal stored in the memory unit 101 is a 0 or a 1. In a case where a high voltage (e.g., 5 V) is applied to the source electrode 113 by the bit line 32, the data "1" is written to the memory unit 101, and in a case where a low voltage (e.g., 0 V) is applied to the source electrode 113 by the bit line 32, the data "0" is written to the memory unit 101.

In the above embodiments, the nodal capacitor is a potential difference between the secondary electrode 116 and infinity, or a voltage difference between the secondary electrode 116 and a peripheral electrode such as the source electrode, the gate electrode, and the like.

In a case where the semiconductor memory device 10 is in a reading mode of operation, a second voltage is applied to the gate electrode 115 by the word line 31, such that a voltage difference is present between the gate electrode 115 and the source electrode 113. The transistor is turned on, the charge stored in the secondary electrode 116 is sensed by the detection bit line 32, and at the same time, a magnitude of a current (i.e., an output current of the transistor 11) on the bit line 32 is detected, such that the reading of the data is achieved. In some embodiments, the detection bit line 32 is the bit line as described above, and in this case, an input signal line and a data readout line are the same.

Specifically, in a case where the data "1" is stored in the memory unit 101, the secondary electrode 116 and the drain electrode 112 have a high potential (e.g., +5 V), and the transistor 11 is in the on state under a combined action of the first voltage of the gated electrode and the second voltage of the gated electrode. Thus, a more significant current is measured by the bit line 32. In the case where the more significant current is measured, it is determined that the read data is "1." In a case where the data stored in the memory unit 101 is "0," the potentials on the secondary electrode 116 and the drain electrode 112 are low, and the transistor 11 is still in an off state after the second voltage is applied to the gate electrode 115. Therefore, the current measured by the bit line 32 is very weak, and it is determined that the read data is "0."

It should be noted that the magnitude of a threshold voltage of the transistor 11 is related to the control of the secondary electrode 116. In a case where only the gate electrode is provided, Vth is related to factors such as materials and device structures. In a case where the secondary electrode is present to modulate a semiconductor channel of the transistor, the Vth of the transistor is negatively biased.

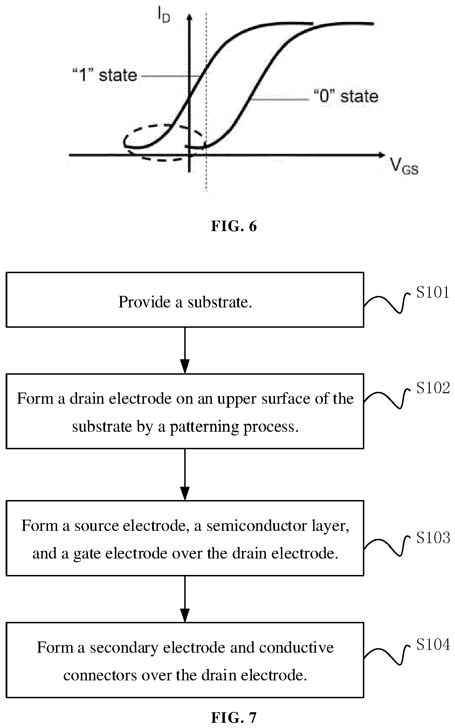

For an N-type field effect transistor (where carriers are electrons when the transistor is on), the higher the potentials (e.g., +5 V) on the secondary electrode 116 and the drain electrode 112, the lower the turn-on voltage of the gate electrode of the transistor (i.e., negative bias on the threshold voltage). That is, the transistor 11 is on in a case where a voltage difference between the gate electrode 115 and the source electrode 113 is small. The lower the potentials on the secondary electrode 116 and drain electrode 112, the weaker the control effect of the secondary electrode on the channel of the semiconductor layer, and the threshold voltage is not affected by the secondary electrode. Accordingly, in the case where the same second voltage is applied to the gate electrode 115, refer to FIG. 6, where a horizontal coordinate is the voltage applied to the gate electrode 115 (i.e., the second voltage) and a vertical coordinate is the output current of the transistor 11. In a case where the voltage applied to the gate electrode 115 is a particular value (a dotted-line position in FIG. 6), the levels of the voltages on the secondary electrode 116 and the drain electrode 112 (i.e., whether the data written by the transistor 11 is "1" or "0") cause the magnitude of the output current of the transistor (i.e., the current measured by the bit line 32) have a significant difference. The data is read out from the memory unit 101 by detecting the current on the bit line 32. In the case where the transistor 11 writes the data "1," the output current of the transistor 11 is large, and therefore the read data is also "1." In the case where the data written by the transistor 11 is "0," the output current of the transistor 11 is extremely weak, and therefore the data read is also "0."

In this way, by increasing the control of the secondary electrode on the semiconductor channel, the transistor gets a large current at a small turn-on voltage, and it is not easy to turn off the transistor when it is turned on. In a case where the transistor is turned off, it requires a large voltage to turn on, which is not easy. Therefore, a dark current at turn on or turn off is reduced, and the ability of the device to store charges and hold charges is improved. In some embodiments, a refreshing frequency is reduced.

A value of the second voltage is determined based on the parameters of the transistor and the magnitudes of the voltages applied to the secondary electrode 116 and the drain electrode 112 during the writing operation. It should be noted that the value of the second voltage needs to be suitable (it needs to be between a threshold voltage when the transistor stores "1" and a threshold voltage when the transistor stores "0"). In a case where the value of the second voltage is not suitable, the output current of the transistor 11 when storing data "1" (i.e., when the potentials on the drain electrode 112 and the secondary electrode 116 are high) and the output current of the transistor 11 when storing data "0" (i.e., when the potentials on the drain electrode 112 and the secondary electrode 116 are low) are very close to each other, and therefore, it is difficult to determine whether the read data is "0" or "1" during the reading operation, which affects the performance of the semiconductor memory device 10. The most suitable value of the second voltage is determined by experiments or simulation, such that a difference between the output currents of the transistor 11 when performing the reading operation in different states is maximized, and thus the reading performance is improved.

In the semiconductor memory device 10 provided by the present disclosure, one transistor 11 is arranged in each memory unit 101. The gate electrode 115 and the secondary electrode 116 are arranged in the transistor 11, and the secondary electrode 116 is electrically connected to the drain electrode 112. The first voltage is applied to the gate electrode 115 by the word line 31 during the writing operation, and then an electrical signal is applied to the source electrode 113 over the bit line 32 based on external input data. The source electrode 113 transmits the electrical signal to the drain electrode 112, the drain electrode 112 transmits the electrical signal to the secondary electrode 116, and the node capacitors of the secondary electrode 116 and the drain electrode 112 constitute the memory capacitor of the memory unit 101. In this way, the writing of data (writing of "1" or "0") is achieved. During the reading operation, the second voltage is applied to the secondary electrode 116 by the word line 31 using the influence of the voltage of the secondary electrode 116 on the threshold voltage of the transistor 11 (the magnitude of the second voltage is between the threshold voltage of the transistor 11 when storing "1" and the threshold voltage of the transistor 11 when storing "0"), and then the data is read out by detecting the magnitude of the output current of the field effect transistor. Therefore, compared with the related art in which the memory unit is provided with the 2T1C or 2T0C structure, the reading and writing of the data is achieved by providing only one transistor 11 in the memory unit 101 in the embodiments of the present disclosure, and there is no need to provide other transistors and capacitors, which greatly simplifies the structure of the memory unit 101 and is conducive to improving the degree of integration and the memory density of the semiconductor memory device 10. In addition, it is easy to form a multilayer structure of the semiconductor memory device 10 by stacking the memory units 101, which simplifies the formation process of the semiconductor memory device 10.

In some embodiments of the present disclosure, the gate electrode 115, the secondary electrode 116, the semiconductor layer 114, and the source electrode 113 are arranged on a side, away from the substrate 110, of the drain electrode 112, and specific positions of the gate electrode 115, the secondary electrode 116, the semiconductor layer 114, and the source electrode 113 are adjusted according to the actual needs. In the embodiments, as shown in FIG. 1 and FIG. 2, orthographic projections of the gate electrode 115, the secondary electrode 116, the source electrode 113, and the semiconductor layer 114 on the substrate 110 are all within the orthographic projection of the drain electrode 112 on the substrate 110, such that an area occupied by the transistor 11 is reduced, and thus the structural layout of the semiconductor memory device 10 is more compact, which is more conducive to the integration of the device.

As shown in FIG. 1 and FIG. 2, in the embodiments, the secondary electrode 116 surrounds the gate electrode 115, and the semiconductor layer 114 is arranged between the gate electrode 115 and the secondary electrode 116. By making the secondary electrode 116 surround the gate electrode 115, an area of an overlapping region between the gate electrode 115, the secondary electrode 116, and the semiconductor layer 114 is maximized, such that the influence of the secondary electrode 116 on the threshold voltage of the transistor 11 is increased. That is, in a case where the voltages on the secondary electrode 116 are different, applying the same threshold voltage makes the output current of the transistor vary considerably, which facilitates differentiation of the read data during the reading operation, and thus the accuracy of the read data is improved. It should be noted that thicknesses of layers of the gate electrode 115 and the secondary electrode 116 in the first direction in FIG. 1 are determined according to the actual needs, which are not limited herein.

In some embodiments of the present disclosure, a material of the semiconductor layer 114 includes a metal oxide semiconductor material. Because of the inherent characteristics of the metal oxide semiconductor (factors such as low electron mobility), in a case where the semiconductor layer 114 is made of metal oxide, the leakage current of the transistor 11 is small, and a rate of charge loss on the memory capacitor is reduced. Therefore, the data retention time of the semiconductor memory device 10 is prolonged, which is conducive to lowering the refreshing frequency and power consumption of the semiconductor memory device 10.

The metal oxide material is Indium Gallium Zinc Oxide (IGZO). In a case where the metal oxide material is IGZO, the leakage current of the transistor 11 is small (the leakage current is less than or equal to 10⁻¹⁵ A), such that the operating performance of the semiconductor memory device is ensured. It should be noted that the metal oxide material is ITO, IWO, ZnOₓ, InOₓ, In₂O₃, InWO, SnO₂, TiOₓ, InSnOₓ, ZnₓO_{y}N_{z}, MgₓZn_{y}O_{z}, InₓZn_{y}O_{z}, InₓGa_{y}Zn_{z}Oₐ, ZrₓIn_{y}Zn_{z}Oₐ, HfₓIn_{y}Zn_{z}Oₐ, SnₓIn_{y}Zn_{z}Oₐ, AlₓSn_{y}In_{z}ZnₐO_{d}, SiₓIn_{y}Zn_{z}Oₐ, ZnₓSn_{y}O_{z}, AlₓZn_{y}Sn_{z}Oₐ, GaₓZn_{y}Sn_{z}Oₐ, ZrₓZn_{y}Sn_{z}Oₐ, or InGaSiO, which is adjusted according to the actual needs, as long as the leakage current of the transistor meets the requirement.

It should be noted that the specific way of achieving the electrical connection between the secondary electrode 116 and the drain electrode 112 is determined according to the actual needs. In the embodiments, as shown in FIG. 1 and FIG. 2, the transistor 11 also includes a conductive connector 119, the conductive connector 119 is arranged on the side, away from the substrate 110, of the drain electrode 112, and the secondary electrode 116 is electrically connected to the drain electrode 112 by the conductive connector 119. In the formation process of the semiconductor memory device 10, after the drain electrode 112 and the secondary electrode 116 are formed, the conductive connector 119 is formed by depositing a metal material on the drain electrode 112, which is easier in process. The conductive connector 119 is made of copper, aluminum, or other materials having good electrical conductivity, which is not limited herein. The size and position of the conductive connector 119 are adjusted according to the actual needs. In the embodiments, as shown in FIG. 1 and FIG. 2, the conductive connector 119 surrounds the secondary electrode 116, and thus contact areas of the conductive connector 119 with the secondary electrode 116 and the drain electrode 112 are maximized, which is conducive to improving the electrical connection performance between the secondary electrode 116 and the drain electrode 112.

In some embodiments, as shown in FIG. 1 to FIG. 5, the semiconductor memory device 10 includes a plurality of stacked array modules 102. Each of the array modules 102 includes a plurality of memory units 101 arranged in an array. Specifically, the word lines 31 (not shown in FIG. 3) of the plurality of memory units 101 are connected to each other, and the bit lines 32 (not shown in FIG. 3) of the plurality of memory units 101 are connected to each other, such that a layer of array modules is formed. A plurality of layers of array modules 102 are stacked to form the semiconductor memory device 10 in a three-dimensional structure. In this way, the memory capacity of the semiconductor memory device 10 is increased while the area occupied by the semiconductor memory device 10 is reduced, which facilitates the integration of the device.

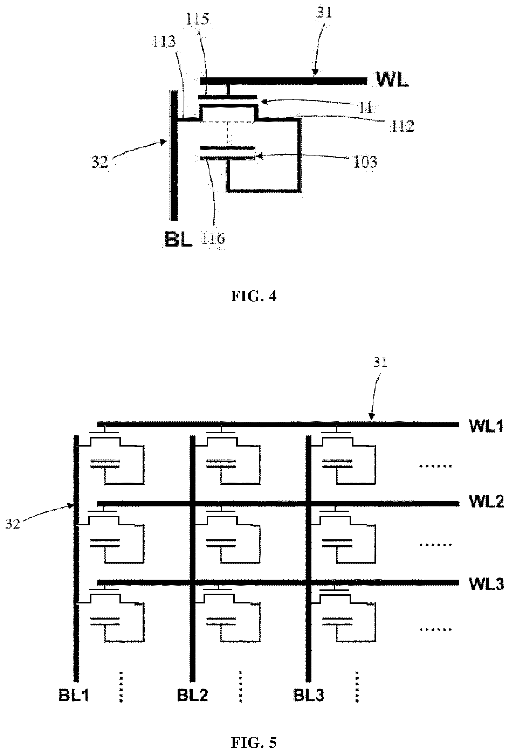

Based on the same inventive conception, some embodiments of the present disclosure further provide a memory circuit. As shown in FIG. 4, the memory circuit includes a gate electrode 115, a secondary electrode 116, a source electrode 113, a drain electrode 112, a word line 31, and a bit line 32. The gate electrode 115 is electrically connected to the word line 31, the source electrode 113 is electrically connected to the bit line 32, the drain electrode 112 is electrically connected to the secondary electrode 116, the gate electrode 115 and the secondary electrodes 116 are insulated from each other, the gate electrode 115 is insulated from the source electrode 113 and the drain electrode 112, and node capacitors of the secondary electrode 116 and the drain electrode 112 form a memory capacitor 103.

Based on the same inventive conception, some embodiments of the present disclosure further provide an electronic device. The electronic device includes the semiconductor memory device 10 described above according to some embodiments of the present disclosure or includes the memory circuit described above according to some embodiments of the present disclosure. Because the electronic device includes the semiconductor memory device 10 described above according to some embodiments of the present disclosure, the electronic device has the same beneficial effect as the semiconductor memory device 10, which is not repeated herein.

Specifically, the electronic device according to some embodiments of the present disclosure includes a memory device, a smartphone, a computer, a tablet computer, an artificial intelligence device, a wearable device, or a mobile power source., which is determined based on the actual needs. The memory device includes, for example, memory in a computer, which is not limited herein.

Based on the same inventive concept, some embodiments of the present disclosure further provide a method for manufacturing a semiconductor memory device 10. As shown in FIG. 7, the method includes the following steps.

In S 101, a substrate is provided.

In S102, a drain electrode is formed on a side of the substrate by a patterning process.

In S103, a source electrode, a semiconductor layer, and a gate electrode are successively formed on a side, away from the substrate, of the drain electrode.

In S104, a secondary electrode and conductive connectors are formed on the side, away from the substrate, of the drain electrode.

In the formation method according to some embodiments of the present disclosure, one transistor 11 is arranged in each memory unit 101, wherein the transistor 11 includes the gate electrode 115 and the secondary electrode 116, and the secondary electrode 116 is electrically connected to the drain electrode 112. A first voltage is applied to the gate electrode 115 by a word line 31 during the writing operation, and then an electrical signal is applied to the source electrode 113 over a bit line 32 based on external input data. The source electrode 113 transmits the electrical signal to the drain electrode 112, the drain electrode 112 transmits the electrical signal to the secondary electrode 116, and node capacitors of the secondary electrode 116 and the drain electrode 112 form a memory capacitor of the memory unit 101, such that the writing of the data is achieved. During the reading operation, a second voltage is applied to the secondary electrode 116 by the word line 31 (a magnitude of the second voltage is between a threshold voltage of the transistor 11 when storing "1" and a threshold voltage of the transistor 11 when storing "0"), and then the data is read out by detecting a magnitude of an output current of a field effect transistor. Therefore, the reading and writing of data is achieved by providing only one transistor 11 in the memory unit 101, and there is no need to provide other transistors 11 and capacitors, which greatly simplifies the structure of the memory unit 101 and is conducive to improving the degree of integration and memory density of the semiconductor memory device 10.

In some embodiments, successively forming the source electrode 113, the semiconductor layer 114, and the gate electrode 115 on the side, away from the substrate 110, of the drain electrode 112 includes:
forming a sacrificial layer on the side, away from the substrate, of the drain electrode, the sacrificial layer covering the drain electrode;
forming the source electrode on a side, away from the substrate, of the sacrificial layer by a patterning process, an orthographic projection of the source electrode on the substrate being within an orthographic projection of the drain electrode on the substrate;
forming a first dielectric layer on a side, from the substrate, of the source electrode away, the first dielectric layer covering the source electrode and the drain electrode;
opening a via successively running through the first dielectric layer, the source electrode, and the sacrificial layer, a bottom of the via exposing the drain electrode, and a wall of the via exposing the source electrode; and
successively forming the semiconductor layer, a first insulator layer, and the gate electrode within the via, the semiconductor layer being electrically connected to the source electrode and the drain electrode.

In some embodiments, forming the secondary electrode 116 and the conductive connectors 119 on the side, away from the substrate 110, of the drain electrode 112 includes:
exposing two ends of the drain electrode by removing portions of the first dielectric layer and the sacrificial layer by a patterning process;
exposing the drain electrode, the source electrode, and the semiconductor layer by forming an accommodation space by removing the remaining sacrificial layer;
forming a second insulator layer by deposition and causing the second insulator layer to cover the exposed semiconductor layer, the exposed source electrode 113, and the exposed drain electrode;
forming the secondary electrode on a surface of the second insulator layer by deposition and causing the secondary electrode to fill the accommodation space; and
forming the conductive connectors at the two ends of the exposed drain electrode by deposition, and causing each of the conductive connectors to be connected to both the drain electrode and the secondary electrode.

In some embodiments of the present disclosure, after forming the secondary electrodes 116 and the conductive connectors 119 on the side, away from the substrate 110, of the drain electrode 112, the method further includes:
forming a word line by a patterning process and causing the word line to be electrically connected to the gate electrode; and
forming a bit line by a patterning process and causing the bit line to be electrically connected to the source electrode.

The manufacturing process of the semiconductor memory device 10 in the embodiments of the present disclosure is described in further detail hereinafter in conjunction with the accompanying drawings. Specifically, the patterning process in some embodiments of the present disclosure includes some or all of the processes of photoresist coating, exposure, development, etching, and removal of photoresist.

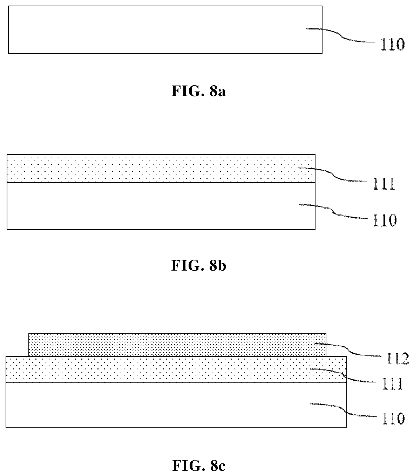

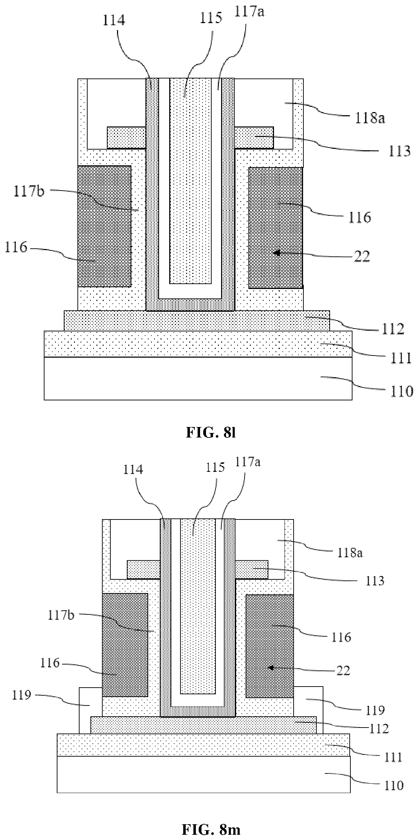

As shown in FIG. 8a, first, a substrate 110 is provided. A material of the substrate 110 includes silicon or glass.

As shown in FIG. 8b, next, an interlayer insulator layer 111 is formed on a side of the substrate 110.

As shown in FIG. 8c, next, a drain electrode 112 is formed on a side, away from the substrate 110, of the interlayer insulator layer 111 by a patterning process.

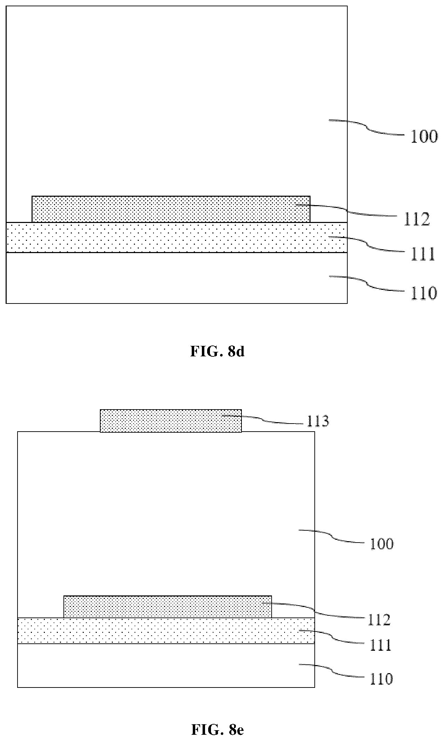

As shown in FIG. 8d, next, a sacrificial layer 100 is formed on a side, away from the substrate 110, of the drain electrode 112, and the sacrificial layer 100 is made to cover the drain electrode 112. A material of the sacrificial layer 100 includes an organic material or an inorganic material.

As shown in FIG. 8e, next, a source electrode 113 is formed on a side, away from the substrate 110, of the sacrificial layer 100 by a patterning process, and an orthographic projection of the source electrode 113 on the substrate 110 is made to be within an orthographic projection of the drain electrode 112 on the substrate 110.

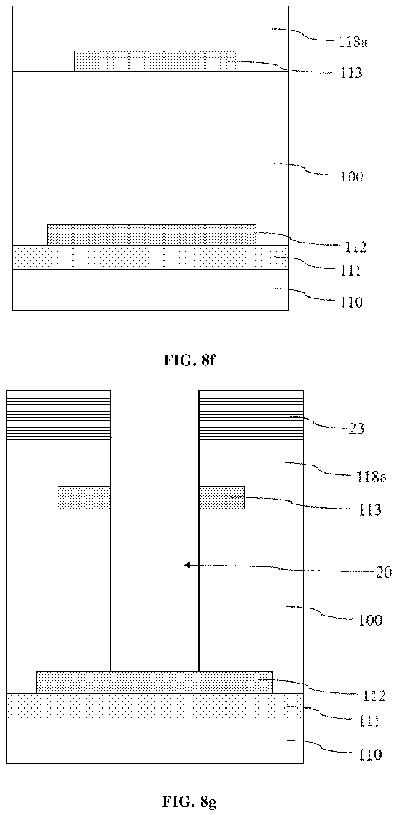

As shown in FIG. 8f, next, a first dielectric layer 118a is formed on a side, away from the substrate 110, of the source electrode 113, and the first dielectric layer 118a is made to cover the source electrode 113 and the drain electrode 112. A material of the first dielectric layer 118a includes an inorganic material such as silicon oxide or silicon nitride.

As shown in FIG. 8g, next, a mask 23 is utilized to shield a portion region on the first dielectric layer 118a, a via 20 is opened in the first dielectric layer 118a not shielded by the mask 23, and the via 20 is made to successively run through the first dielectric layer 118a, the source electrode 113, and the sacrificial layer 100. A bottom of the via 20 exposes the drain electrode 112, and a wall of the via 20 exposes the source electrode 113.

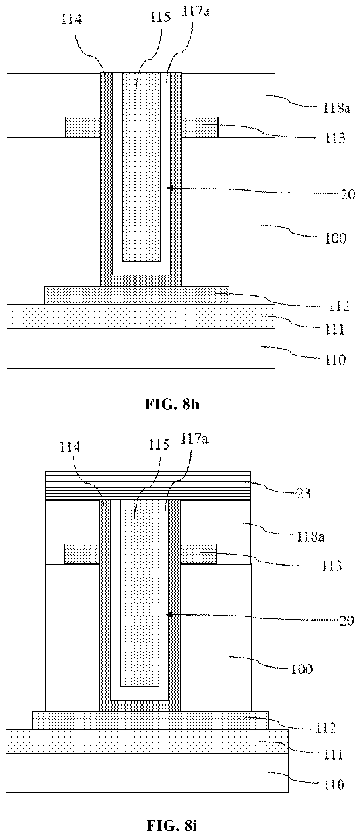

As shown in FIG. 8h, next, a semiconductor layer 114, a first insulator layer 117a, and a gate electrode 115 are successively formed within the via 20 by a process such as atomic deposition, chemical vapor deposition, or physical vapor deposition, and the semiconductor layer 114 is electrically connected to the source electrode 113 and the drain electrode 112. A material of the semiconductor layer 114 includes a metal oxide such as IGZO, a material of the first insulator layer 117a includes a material having a good insulating property such as aluminum oxide, and a material of the gate electrode 115 includes titanium nitride, tungsten, or other materials having a good conductive property. Thereafter, surfaces, away from the substrate 110, of the semiconductor layer 114, the first insulator layer 117a, and the gate electrode 115 are ground by a chemical mechanical polishing process, such that the semiconductor layer 114, the first insulator layer 117a, the gate electrode 115, and the first dielectric layer 118a are flush.

As shown in FIG. 8i, next, portions of the first dielectric layer 118a and the sacrificial layer 100 are removed by a patterning process, such that two ends of the drain electrode 112 are exposed. Specifically, regions corresponding to the semiconductor layer 114, the first insulator layer 117a, and the gate electrode 115 are shielded by a mask, and the portions, disposed at the two ends, of the first dielectric layer 118a and the sacrificial layer 100 are etched away.

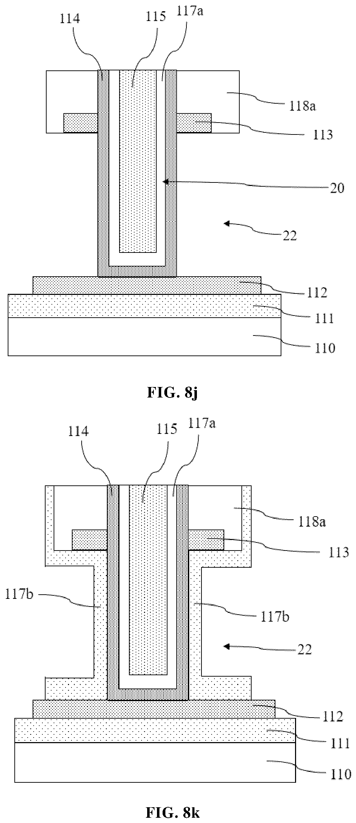

As shown in FIG. 8j, next, an accommodation space 22 is formed by removing the remaining sacrificial layer 100 by an etching process, such that the drain electrode 112, the source electrode 113, and the semiconductor layer 114 are exposed.

As shown in FIG. 8k, next, a second insulator layer 117b is formed within the accommodation space 22 by a deposition process, and the second insulator layer 117b is made to cover the exposed semiconductor layer 114, the exposed source electrode 113, and the exposed drain electrode 112.

As shown in FIG. 8I, next, a secondary electrode 116 is formed on a surface of the second insulator layer 117b by deposition and the secondary electrode 116 is made to fill the accommodation space 22. Thereafter, a side of the secondary electrode 116 is etched by an etching process, such that the secondary electrodes 116 of adjacent memory units are isolated from each other.

As shown in FIG. 8m, next, conductive connectors 119 are formed by deposition at the two ends of the exposed drain electrode 112, and each of the conductive connectors 119 is connected to both the drain electrode 112 and the secondary electrodes 116, such that the manufacturing of the transistor 11 is completed.

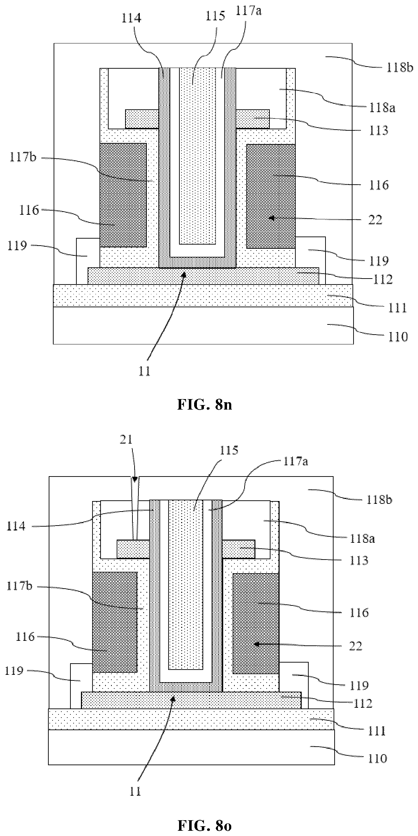

As shown in FIG. 8n, next, a second dielectric layer 118b is formed on a side of the substrate 110 by a deposition process, and the second dielectric layer 118b is made to cover the transistor 11.

As shown in FIG. 8o, next, a through passage 21 is opened in the second dielectric layer 118b at a position corresponding to the source electrode 113.

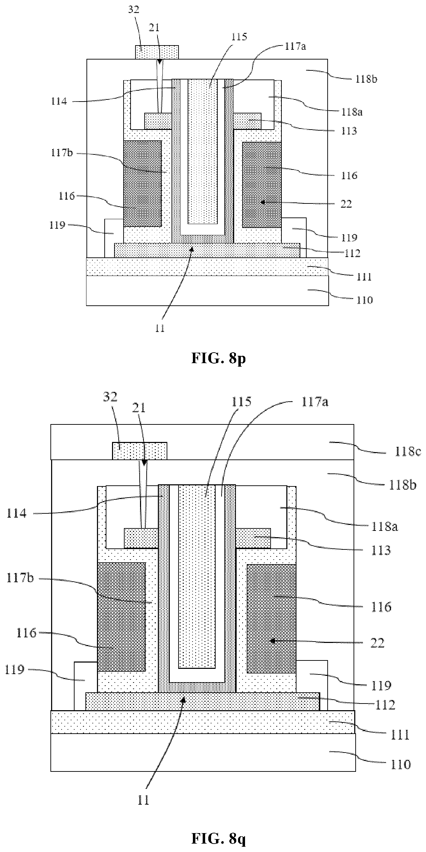

As shown in FIG. 8p, next, a bit line 32 is formed on a side, away from the substrate 110, of the second dielectric layer 118b by a patterning process, and the bit line 32 is made to be electrically connected to the source electrode 113 via the through passage 21.

As shown in FIG. 8q, next, a third dielectric layer 118c is deposited on the second dielectric layer 118b.

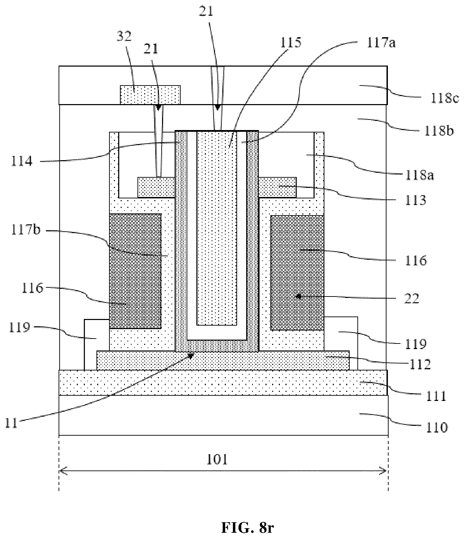

As shown in FIG. 8r, next, a through passage 21 is opened in the third dielectric layer 118c at a position corresponding to the gate electrode 115.

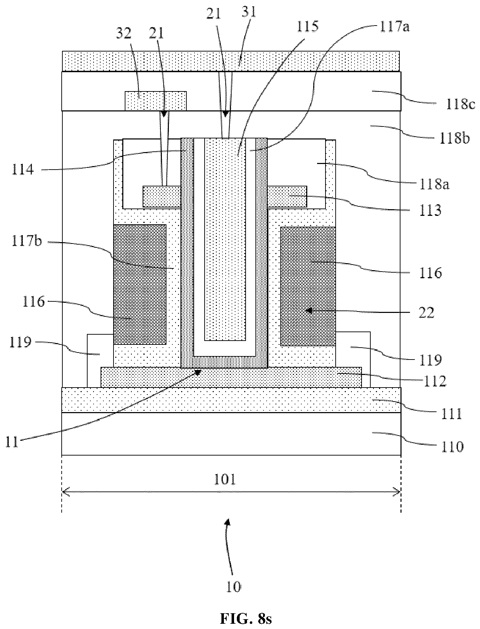

As shown in FIG. 8s, next, a word line 31 is formed on a side, away from the substrate 110, of the third dielectric layer 118c by a patterning process, and the word line 31 is made to be electrically connected to the gate electrode 115 via the through passage 21.

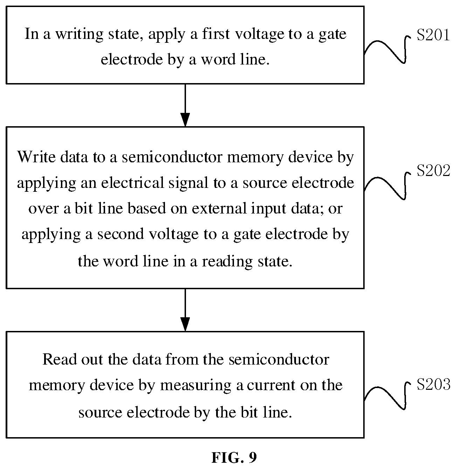

Based on the same inventive concept, some embodiments of the present disclosure further provide a method for reading and writing a semiconductor memory device 10. As shown in FIG. 9, the method includes the following steps.

In S201, a first voltage is applied to the gate electrode by a word line in a writing state.

In S202, data is written to a semiconductor memory device by applying an electrical signal to a source electrode over a bit line based on external input data; or applying a second voltage to a gate electrode by the word line in a reading state.

In S203, the data is read out from the semiconductor memory device by measuring a current on the source electrode by the bit line.

Specifically, as shown in FIG. 1 and FIG. 2 (the word line and the bit line are not shown in FIG. 2), in a case where the semiconductor memory device 10 is in the writing mode of operation, the first voltage (e.g., 5 V) is applied to the gate electrode 115 by the word line 31, such that a transistor 11 in an on state. The magnitude of the first voltage is related to factors such as the structure of the transistor 11, the material of the semiconductor layer 114 in the transistor 11, and the like, which is adjusted according to actual needs. In a case where the transistor 11 is on, a voltage is applied to the source electrode 113 by the bit line 32 according to the external input data, the source electrode 113 and a drain electrode 112 are conducted via the semiconductor layer 114, and the drain electrode 112 is electrically connected to a secondary electrode 116, such that the magnitude of the voltage on the source electrode 113 and the magnitude of the voltage on the drain electrode 112 are the same as the magnitude of the voltage on the secondary electrode 116. Node capacitors of the secondary electrode 116 and the drain electrode 112 form a memory capacitor of the memory unit 101, and the magnitude of a gate voltage of the secondary electrode 116 determines the quantity of charges in the memory capacitor, which in turn determines whether a binary of a data signal stored in the memory unit 101 is 0 or 1. In a case where a high voltage is applied to the source electrode 113 (e.g., 5 V) by the bit line 32, the data "1" is written to the memory unit 101, and in a case where a low voltage (e.g., 0 V) is applied to the source electrode 113 by the bit line 32, the data "0" is written to the memory unit 101.

In a case where the semiconductor memory device 10 is in the reading mode of operation, the second voltage is applied to the gate electrode 115 by the word line 31, such that there is a voltage difference exists between the gate electrode 115 and the source electrode 113, and at the same time, the reading of the data is achieved by detecting the magnitude of the current (i.e., an output current of the transistor 11) on the bit line 32. Specifically, in a case where the data "1" is stored in the memory unit 101, the secondary electrode 116 and the drain electrode 112 have a high potential, and the transistor 11 is in the on state under the combined action of the first voltage and the second voltage, such that a more significant current is measured by the bit line 32. In a case where the more significant current is measured, it is determined that the read data is "1". In a case where the data stored in the memory unit 101 is "0", the voltages on the secondary electrode 116 and the drain electrode 112 are low. After the second voltage is applied to the gate electrode 115, the field effect transistor is still in an off state, and thus the current measured by the bit line 32 is very weak, and the read data is determined to be "0."

It should be noted that the magnitude of a threshold voltage of the transistor 11 is related to the magnitude of the voltages on the secondary electrode 116 and the drain electrode 112. For an N-type field effect transistor (i.e., the semiconductor layer 114 of the transistor 11 is made of an N-type semiconductor material), the higher the potentials on the secondary electrode 116 and the drain electrode 112, the smaller the threshold voltage (i.e., in a case where a voltage difference between the gate electrode 115 and the source electrode 113 is small, the transistor 11 is also capable of having a large output current); and the lower the potentials on the secondary electrode 116 and the drain electrode 112, the larger the threshold voltage. Therefore, when applying the same second voltage to the gate electrode 115, as shown in FIG. 1, FIG. 4, and FIG. 6, the levels of the voltages on the secondary electrode 116 and the drain electrode 112 (i.e., whether the data written by the transistor 11 is "1" or "0") cause a significant difference in the magnitude of the output current of the transistor 11 (i.e., the current measured by the bit line 32). The data is read out from the memory unit 101 by detecting the current on the bit line 32. In a case where the data written by the transistor 11 is "1", the output current of the transistor 11 is larger, and therefore the read data is "1." In a case where the data written by the transistor 11 is "0", the output current of the transistor 11 is extremely weak, and therefore the read data is also "0."

It should be noted that a value of the second voltage is determined according to the parameters of the field effect transistor and the magnitude of the voltages applied to the secondary electrode 116 and the drain electrode 112 during the writing operation. It should be noted that the value of the second voltage needs to be suitable (it needs to be between a threshold voltage when the transistor stores "1" and a threshold voltage when the transistor stores "0"). In a case where the value of the second voltage is not suitable, the output current of the transistor 11 when storing data "1" (i.e., when the potentials on the drain electrode 112 and the secondary electrode 116 are high) and the output current of the transistor 11 when storing data "0" (i.e., when the potentials on the drain electrode 112 and the secondary electrode 116 are low) are very close to each other, and therefore, it is difficult to determine whether the read data is "0" or "1" during the reading operation, which affects the performance of the semiconductor memory device 10. In practice, the most suitable value of the second voltage is determined by experiments or simulation, such that a difference between the output currents of the transistor 11 when performing the reading operation in different states is maximized, and thus the reading performance is improved.

At least the following beneficial effects are achieved by applying the embodiments of the present disclosure.

In the semiconductor memory device 10 provided by the present disclosure, one transistor 11 is arranged in each memory unit 101, wherein the gate electrode 115 and the secondary electrode 116 are arranged in the transistor 11, and the secondary electrode 116 is electrically connected to the drain electrode 112. The first voltage is applied to the gate electrode 115 by the word line 31 during the writing operation, and then the electrical signal is applied to the source electrode 113 over the bit line 32 based on the external input data. The source electrode 113 transmits the electrical signal to the drain electrode 112, the drain electrode 112 transmits the electrical signal to the secondary electrode 116, and the node capacitors of the secondary electrode 116 and the drain electrode 112 form the memory capacitor of the memory unit 101, such that the writing of the data is achieved. During the reading operation, the second voltage is applied to the secondary electrode 116 by the word line 31 (the magnitude of the second voltage is between the threshold voltage of the transistor 11 when storing "1" and the threshold voltage of the transistor 11 when storing "0") using the influence of the voltage of the secondary electrode 116 on the threshold voltage of the transistor 11, and then the data is read out by detecting the magnitude of the output current of the field effect transistor. Therefore, the reading and writing of data is achieved by providing only one transistor 11 in the memory unit 101, and there is no need to provide other transistors 11 and capacitors, which greatly simplifies the structure of the memory unit 101 and is conducive to improving the degree of integration and memory density of the semiconductor memory device 10.

2. In some embodiments of the present disclosure, the orthographic projections of the gate electrode 115, the secondary electrode 116, the source electrode 113, and the semiconductor layer 114 on the substrate 110 all fall within the orthographic projection of the drain electrode 112 on the substrate 110, such that the area occupied by the transistor 11 is reduced, and thus the structural layout of the semiconductor memory device 10 is more compact, which is conducive to the integration of the device.

3. In some embodiments of the present disclosure, the secondary electrode 116 surrounds the gate electrode 115, such that the area of the overlapping region between the gate electrode 115, the secondary electrode 116, and the semiconductor layer 114 is maximized, and thus the influence of the secondary electrode 116 on the threshold voltage of the transistor 11 is increased. That is, in a case where the voltages on the secondary electrode 116 are different, applying the same threshold voltage makes the output current of the field effect transistor vary considerably, which facilitates differentiation of the read data during the reading operation, and thus the accuracy of the read data is improved.

4. In a case where the semiconductor layer 114 is made of metal oxide, the leakage current of the transistor 11 is small (in a case where the metal oxide is IGZO, the leakage current is less than or equal to 10⁻¹⁵ A), and a rate of charge loss on the memory capacitor is reduced. Therefore, the data retention time of the semiconductor memory device 10 is prolonged, which is conducive to lowering the refreshing frequency and power consumption of the semiconductor memory device 10.

5. In some embodiments of the present disclosure, the plurality of memory units 101 are arranged to form the array module 102, and then the plurality of layers of array modules 102 are stacked to form the semiconductor memory device 10 in a three-dimensional structure. In this way, the memory capacity of the semiconductor memory device 10 is increased while the area occupied by the semiconductor memory device 10 is reduced, which facilitates the integration of the device.

In the description of the present disclosure, it should be understood that the orientations or positional relationships indicated by the terms "center," "up," "down," "front," "back," "left," "right," "vertical," "horizontal," "top," "bottom," "inner," "outer, " and the like are orientations or positional relationships based on the accompanying drawings, and are intended only to facilitate and simplify the description of the present disclosure, and are not intended to indicate or imply that the referred device or element must have a particular orientation, or be constructed and operated in a particular orientation, and therefore are not to be construed as limitations on the present disclosure.

The terms "first" and "second" are only used for descriptive purposes, and cannot be understood as indicating or implying relative importance or the number of technical features indicated. Thus, a feature defined by the terms "first" or "second" may expressly or impliedly include one or more such features. In the present disclosure, the term "a plurality of" refers to two or more, unless expressly defined otherwise.

In the description of this specification, specific features, structures, materials, or characteristics may be combined in any one or more embodiments or examples appropriately.

The above descriptions are only some of the embodiments of the present disclosure, and it should be noted by those in the art that various improvements and embellishments may be made without departing from the principles of the present disclosure, and these improvements and embellishments should also be regarded as the scope of protection of the present disclosure.

## Claims

1. A semiconductor memory device, comprising: a substrate and a plurality of memory units disposed on the substrate, each of the memory units comprising a transistor, a bit line, and a word line; wherein
the transistor comprises:
a drain electrode, arranged over the substrate;
a gate electrode, arranged over the drain electrode, wherein the gate electrode is insulated from the drain electrode, and the gate electrode is electrically connected to the word line;
a secondary electrode, arranged over the drain electrode surrounding an outer sidewall of the gate electrode, wherein the secondary electrode is insulated from the gate electrode, the secondary electrode is not overlapped with the gate electrode in a first direction perpendicular to an upper surface of the substrate, and the secondary electrode is electrically connected to the drain electrode;
a semiconductor layer, surrounding the gate electrode, wherein the semiconductor layer is insulated from the gate electrode and the secondary electrode, and the semiconductor layer is electrically connected to the drain electrode; and
a source electrode, arranged over the secondary electrode surrounding the outer sidewall of the gate electrode, wherein the source electrode is electrically connected to the semiconductor layer and the bit line, and the source electrode is insulated from the gate electrode and the secondary electrode.

2. The semiconductor memory device according to claim 1, wherein the secondary electrode is at least partially overlapped with the source electrode in the first direction.

3. The semiconductor memory device according to claim 2, wherein the secondary electrode is at least partially overlapped with the drain electrode in the first direction.

4. The semiconductor memory device according to claim 3, wherein an orthographic projection of an outer sidewall of the secondary electrode on a plane parallel to the upper surface of the substrate is outside an orthographic projection of the source electrode on the plane and within an orthographic projection of the drain electrode on the plane.

5. The semiconductor memory device according to claim 1, wherein the semiconductor layer is arranged between the gate electrode and the secondary electrode.

6. The semiconductor memory device according to claim 3, further comprising: a conductive connector, wherein the secondary electrode is electrically connected to the drain electrode via the conductive connector.

7. The semiconductor memory device according to claim 6, wherein the conductive connector surrounds the secondary electrode.

8. The semiconductor memory device according to any one of claims 1 to 7, wherein the semiconductor layer comprises a monocrystalline semiconductor material, a polycrystalline semiconductor material, or a metal oxide semiconductor.

9. The semiconductor memory device according to claim 8, wherein the metal oxide semiconductor comprises at least one of In, Ga, Zn, Sn, or W.

10. The semiconductor memory device according to any one of claims 1 to 9, comprising: a plurality of stacked array modules, each of the stacked array modules comprising a plurality of the memory units arranged in an array; wherein
the gate electrodes in each row of the transistors are connected to one of the word lines; and
the source electrodes in each column of the transistors are connected to one of the bit lines.

11. A semiconductor memory device, comprising:
a gate electrode, arranged on a substrate, extending in a first direction perpendicular to an upper surface of the substrate, and having a column shape, wherein the gate electrode is electrically connected to a word line;
a semiconductor layer, wherein at least a portion of the semiconductor layer surrounds a sidewall of the gate electrode;
a source electrode, surrounding an outer sidewall of the semiconductor layer and electrically connected to the semiconductor layer, wherein the source electrode is electrically connected to a bit line;
a drain electrode, electrically connected to the semiconductor layer at a lower portion of the semiconductor layer, wherein the drain electrode is spaced apart from the source electrode in the first direction;
a first insulator layer, arranged between the gate electrode and the semiconductor layer and between the gate electrode and the drain electrode;
a secondary electrode, surrounding the outer sidewall of the semiconductor layer between the source electrode and the drain electrode in the first direction; and
a second insulator layer, disposed between the secondary electrode and the semiconductor layer and between the secondary electrode and the source electrode, such that the secondary electrode is insulated from both the semiconductor layer and the source electrode, wherein the secondary electrode is electrically connected to the drain electrode.

12. The semiconductor memory device according to claim 11, wherein the secondary electrode extends in the first direction from the source electrode toward the drain electrode.

13. The semiconductor memory device according to claim 12, wherein the secondary electrode is at least partially overlapped with the drain electrode in the first direction.

14. The semiconductor memory device according to claim 13, wherein an orthographic projection of an outer sidewall of the secondary electrode on a plane parallel to the upper surface of the substrate is outside an orthographic projection of the source electrode on the plane and within an orthographic projection of the drain electrode on the plane.

15. The semiconductor memory device according to claim 11, wherein the semiconductor layer surrounds the sidewall of the gate electrode and a lower surface of the gate electrode in a U-like pattern, and the first insulator layer is formed between the semiconductor layer and the gate electrode in a U-like pattern such that the semiconductor layer is insulated from the gate electrode.

16. The semiconductor memory device according to claim 15, wherein the drain electrode is arranged to surround a lower portion of the outer sidewall of the semiconductor layer and to be in contact with the lower portion of the outer sidewall of the semiconductor layer.

17. The semiconductor memory device according to claim 15, wherein the drain electrode is disposed between the substrate and the semiconductor layer and is in contact with a lower surface of the semiconductor layer.

18. The semiconductor memory device according to claim 17, wherein the drain electrode comprises a first portion disposed between the substrate and the semiconductor layer and a second portion extending outwardly from the first portion in a second direction parallel to the upper surface of the substrate, the second portion of the drain electrode being at least partially overlapped with the secondary electrode in the first direction.

19. The semiconductor memory device according to claim 18, wherein the second portion of the drain electrode is in direct contact with the secondary electrode.

20. The semiconductor memory device according to claim 18, wherein the secondary electrode is spaced apart from the second portion of the drain electrode in the first direction by the second insulator layer, and the secondary electrode is electrically connected to the second portion of the drain electrode by a conductive connector.

21. The semiconductor memory device according to claim 20, wherein the conductive connector surrounds the outer sidewall of the semiconductor layer in an annular pattern and is connected to the second portion of the drain electrode by extending in the first direction.

22. The semiconductor memory device according to claim 21, wherein an orthographic projection of the conductive connector on a plane parallel to the upper surface of the substrate is within an orthographic projection of the secondary electrode on the plane.

23. The semiconductor memory device according to claim 21, wherein
the conductive connector electrically connects a portion of an outer sidewall of the secondary electrode to an end of the second portion of the drain electrode; and
an orthographic projection of the conductive connector on a plane parallel to the upper surface of the substrate is outside an orthographic projection of the secondary electrode on the plane.

24. The semiconductor memory device according to claim 11, wherein the word line and the bit line are both disposed over the gate electrode and are insulated from each other at different layers.

25. The semiconductor memory device according to claim 11, wherein the source electrode and the secondary electrode are at least partially overlapped with each other in the first direction.

26. The semiconductor memory device according to claim 11, further comprising: an additional electrode, at least partially overlapped with the secondary electrode in the first direction.

27. A memory circuit, comprising: a gate electrode, a secondary electrode, a source electrode, a drain electrode, a word line, and a bit line; wherein
the gate electrode is electrically connected to the word line, the source electrode is electrically connected to the bit line, the drain electrode is electrically connected to the secondary electrode, the gate electrode is insulated from the secondary electrode, the gate electrode is insulated from the source electrode and the drain electrode, and the secondary electrode is insulated from the source electrode and the drain electrode; and
node capacitors of the secondary electrode and the drain electrode form a memory capacitor.

28. An electronic device, comprising: the semiconductor memory device as defined in claim 1 or 11.

29. A method for manufacturing a semiconductor memory device, comprising:
providing a substrate;
forming a drain electrode over the substrate by a patterning process;
successively forming a source electrode, a semiconductor layer, and a gate electrode over the drain electrode; and
forming a secondary electrode and conductive connectors over the drain electrode, wherein the secondary electrode is not overlapped with the gate electrode in a first direction perpendicular to an upper surface of the substrate, and each of the conductive connectors are electrically connected to both the secondary electrode and the drain electrode.

30. The method according to claim 29, wherein successively forming the source electrode, the semiconductor layer, and the gate electrode over the drain electrode comprises:
forming a sacrificial layer over the drain electrode, wherein the sacrificial layer covers the drain electrode;
forming the source electrode over the sacrificial layer by a patterning process;
forming a first dielectric layer on the source electrode, wherein the first dielectric layer covers the source electrode and the drain electrode;
opening a via successively running through the first dielectric layer, the source electrode, and the sacrificial layer, wherein a bottom of the via exposes the drain electrode, and a wall of the via exposes the source electrode; and
successively forming the semiconductor layer, the first insulator layer, and the gate electrode within the via, wherein the semiconductor layer is electrically connected to the source electrode and the drain electrode.

31. The method according to claim 30, wherein forming the secondary electrode and the conductive connectors on a side, away from the substrate, of the drain electrode comprises:
exposing two ends of the drain electrode by removing portions of the first dielectric layer and the sacrificial layer by a patterning process;
forming an accommodation space by removing the other portion of the sacrificial layer, such that the drain electrode, the source electrode, and the semiconductor layer are exposed;
forming a second insulator layer by deposition and causing the second insulator layer to cover the exposed semiconductor layer, the exposed source electrode, and the exposed drain electrode;
forming a secondary electrode on the second insulator layer by deposition and causing the secondary electrode to fill the accommodation space; and
forming the conductive connectors at the two exposed ends of the drain electrode by deposition, such that each of the conductive connectors is connected to both the drain electrode and the secondary electrode.

32. The method according to claim 29, wherein after forming the secondary electrode and the conductive connectors on the side, away from the substrate, of the drain electrode, the method further comprises:
forming a word line by a patterning process, such that the word line is electrically connected to the gate electrode; and
forming a bit line by a patterning process, such that the bit line is electrically connected to the source electrode.

33. A method for reading and writing a semiconductor memory device as defined in claim 1 or 11, the method comprising:
in a writing state, turning a transistor on by applying a first voltage to a gate electrode by a word line, and applying a data signal to a source electrode over a bit line, wherein the data signal is stored by the turned-on transistor to a memory capacitor connected to the drain electrode and the secondary electrode; and
in a reading state, applying a second voltage to the gate electrode by the word line, and reading out the data signal by measuring a current on the source electrode by the bit line.
